# EUROPEAN PATENT SPECIFICATION

(11) **EP 4 622 106 B1**
(45) Date of publication and mention of the grant of the patent: **25.11.2026**
(21) Application number: 25305333.4
(22) Date of filing: 13.03.2025
(51) Int. Cl.: H03K 17/082

(54) **SHORT-CIRCUIT PROTECTION CIRCUIT FOR SIC MOS TRANSISTOR**
KURZSCHLUSSSCHUTZSCHALTUNG FÜR SIC-MOS-TRANSISTOR
CIRCUIT DE PROTECTION CONTRE LES COURTS-CIRCUITS POUR TRANSISTOR MOS EN SIC

(30) Priority: 18.03.2024 CN 202420529521 U
(43) Date of publication of application: 24.09.2025
(73) Proprietor: Schneider Electric Industries SAS, 92500 Rueil-Malmaison (FR)
(72) Inventor: HUANG, Jie, Shanghai, 201203 (CN); BI, Baoyun, Shanghai, 201203 (CN); ZHU, Qilei, Shanghai, 201203 (CN)
(74) Representative: Manitz Finsterwald Patent- und Rechtsanwaltspartnerschaft mbB

(56) References cited:
- CN-U- 218 386 794
- US-A1- 2021 028 778

## Description

### FIELD

Embodiments of the present disclosure relate to a field of electrical equipment, and more particularly, to a short-circuit protection circuit for a SiC MOS transistor.

### BACKGROUND

With development of many emerging industries, it is difficult for a conventional Si power semiconductor device to meet a new application of high efficiency and high power density. A SiC metal oxide semiconductor field effect transistor (SiC MOSFET for short) has a low switching loss, a high switching frequency, a high voltage-resistant value and an excellent temperature characteristic, so that conversion efficiency, power density and stability of whole power electronic equipment are greatly improved. However, compared with a Si power semiconductor device, short-circuit bearing capacity of the SiC MOSFET is relatively weak. Therefore, how to improve anti-short-circuit capability of the SiC MOSFET becomes a problem worthy of attention.

An example of short-circuit protection in SiC MOS transistors can be seen in CN 218 386 794 U.

### SUMMARY

An object of the present disclosure is to provide a short-circuit protection circuit for a SiC MOS transistor to at least partially solve above described problems.

In a first aspect of the present disclosure, a short-circuit protection circuit for a SiC MOS transistor is provided, including: a state detection unit connected to a drain of the SiC MOS transistor and a power supply, and configured to generate an indication signal for indicating whether a short-circuit occurs in the power supply; a driving unit, a first input end of the driving unit being connected to a first output end of the state detection unit, and an output end of the driving unit being connected to a gate of the SiC MOS transistor, to drive the SiC MOS transistor to be turned off in response to that the indication signal indicates that a short-circuit occurs in the power supply; and a power supply voltage conversion unit, a first end of the power supply voltage conversion unit being connected to the state detection unit, to switch between a first on position for turning on a first power supply and a second on position for turning on a second power supply based on the indication signal, a second end of the power supply voltage conversion unit being connected to a power supply end of the driving unit, to provide a first power supply voltage of the first power supply or a second power supply voltage of the second power supply to the driving unit, voltage magnitudes of the first power supply voltage and the second power supply voltage being different, the driving unit being configured to provide a first driving voltage to the SiC MOS transistor in response to receiving the first power supply voltage, the driving unit being configured to provide the second driving voltage to the SiC MOS transistor in response to receiving the second power supply voltage, voltage magnitudes of the first driving voltage and the first power supply voltage being the same, and voltage magnitudes of the second driving voltage and the second power supply voltage being the same.

In embodiments according to the present disclosure, short-circuit detection of the power supply can be reliably performed by adopting the state detection unit, the SiC MOS transistor can be reliably driven to be turned off in response to that a short-circuit occurs in the power supply by adopting the driving unit, the first power supply voltage or the second power supply voltage can be reliably supplied to the driving unit by adopting the power supply voltage conversion unit, so that the driving unit provides the first driving voltage or the second driving voltage to the SiC MOS transistor, thereby improving anti-short-circuit capability of the SiC MOS transistor with a characteristic that anti-short-circuit time of the SiC MOS transistor are different under different driving voltages.

In some embodiments, the short-circuit protection circuit further includes a control unit, an input end of the control unit is connected to a second output end of the state detection unit, and an output end of the control unit is connected to a second input end of the driving unit, the control unit is configured to receive the indication signal and generating a turn-on control signal in response to that the indication signal indicates that a short-circuit does not occur in the power supply, so that the driving unit drives the SiC MOS transistor to be turned on under control of the turn-on control signal.

In some embodiments, the state detection unit includes a resistor and a signal generation unit, the resistor is connected between the drain of the SiC MOS transistor and the power supply, a first input end of the signal generation unit is connected to a node between the resistor and the power supply, a second input end of the signal generation unit is connected to a node between the resistor and the drain of the SiC MOS transistor, a first output end of the signal generation unit is connected to a first input end of the driving unit and a first end of the power supply voltage conversion unit, a second output end of the signal generation unit is connected to an input end of the control unit, and the signal generation unit is configured to generate the indication signal in response to that a short-circuit occurs in the power supply.

In some embodiments, the short-circuit protection circuit further includes a triode, a base of the triode is connected to the second output end of the signal generation unit, an emitter of the triode is connected to an output end of the control unit, and a collector of the triode is connected to ground; and the triode is turned on in response to that a voltage magnitude of the indication signal is greater than a predetermined threshold.

In some embodiments, a ground end of the driving unit is connected to the collector of the triode, and the driving unit is configured to drive the SiC MOS transistor to be turned off in response to that the triode is turned on.

In some embodiments, a source of the SiC MOS transistor is connected to an external load.

It should be appreciated that content described in the summary is not intended to limit critical or important features of embodiments of the present disclosure, nor is it intended to limit a scope of the disclosure. Other features of the present disclosure will be readily appreciated from following description.

### BRIEF DESCRIPTION OF THE DRAWINGS

The above and other features, advantages, and aspects of various embodiments of the present disclosure will become more apparent with reference to following detailed description taken in conjunction with drawings. In the drawings, the same or similar reference numerals represent the same or similar elements, wherein:

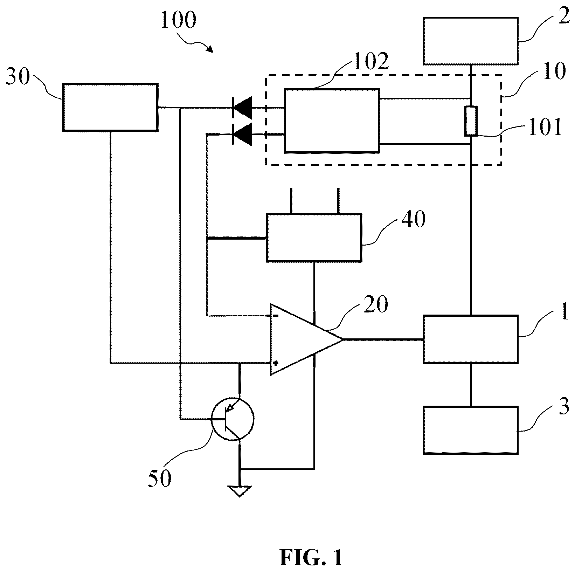

FIG. 1 illustrates a circuit block diagram of a short-circuit protection circuit according to an embodiment of the present disclosure.

### DETAILED DESCRIPTION

Preferred embodiments of the present disclosure will be described in more detail below with reference to drawings. While the preferred embodiments of the present disclosure are shown in the drawings, it should be understood that the present disclosure may be implemented in various forms and should not be limited to the embodiments set forth herein. Rather, these embodiments are provided to make the present disclosure more thorough and complete, and to completely convey the scope of the disclosure to those skilled in the art.

The term "including" and variations thereof, as used herein, mean open-ended including, that is, "including but not limited to." Unless specifically stated otherwise, the term "or" means "and/or." The term "based on" means "based at least in part on." The term "another embodiment" means "at least one further embodiment." The terms "first, " "second, " and the like may refer to different or identical objects.

As described above, compared with the silicon power semiconductor device, the short-circuit bearing capacity of the SiC MOSFET is relatively weak. Therefore, how to improve the anti-short-circuit capability of the SiC MOSFET becomes a problem worthy of attention. Embodiments of the present disclosure provide a short-circuit protection circuit for a SiC MOS transistor, short-circuit detection of a power supply can be reliably performed by adopting the state detection unit, the SiC MOS transistor can be reliably driven to be turned off in response to that a short-circuit occurs in the power supply by adopting a driving unit, a first power supply voltage or a second power supply voltage can be reliably supplied to the driving unit by adopting the power supply voltage conversion unit, so that the driving unit provides the first driving voltage or the second driving voltage to the SiC MOS transistor, thereby improving the anti-short-circuit capability of the SiC MOS transistor with a characteristic that anti-short-circuit time of the SiC MOS transistor are different under different driving voltages. Hereinafter, a principle of the present disclosure will be described in conjunction with FIG. 1.

FIG. 1 illustrates a circuit block diagram of a short-circuit protection circuit 100 according to an embodiment of the present disclosure. As shown in FIG. 1, the short-circuit protection circuit 100 generally includes a state detection unit 10, a driving unit 20, and a power supply voltage conversion unit 40. The state detection unit 10 is connected to a drain of a SiC MOS transistor 1 and a power supply 2. The state detection unit 10 is configured to generate an indication signal for indicating whether a short-circuit occurs in the power supply 2. A first input end of the driving unit 20 is connected to a first output end of the state detection unit 10, and an output end of the driving unit 20 is connected to a gate of the SiC MOS transistor 1. A source of the SiC MOS transistor 1 is connected to an external load 3. The driving unit 20 is configured to receive an indication signal and driving the SiC MOS transistor 1 to turn off in response to that the indication signal indicates a short-circuit occurs in the power supply 2. A first end of the power supply voltage conversion unit 40 is connected to the state detection unit 10. The power supply voltage conversion unit 40 is configured to switch between a first on position for turning on a first power supply and a second on position for turning on a second power supply based on the indication signal, a second end of the power supply voltage conversion unit 40 is connected to a power supply end of the driving unit 20, to provide a first power supply voltage of the first power supply or a second power supply voltage of the second power supply to the driving unit. Voltage magnitudes of the first power supply voltage and the second power supply voltage are different. The driving unit 20 is configured to provide a first driving voltage to the SiC MOS transistor 1 in response to receiving the first power supply voltage, the driving unit is configured to provide a second driving voltage to the SiC MOS transistor 1 in response to receiving the second power supply voltage. Voltage magnitudes of the first driving voltage and the first power supply voltage are the same, and Voltage magnitudes of the second driving voltage and the second power supply voltage are the same.

**In** an embodiment, as shown in FIG. 1, the short-circuit protection circuit 100 may further include a control unit 30. An input end of the control unit 30 is connected to a second output end of the state detection unit 10, and an output end of the control unit 30 is connected to a second input end of the driving unit 20. The control unit 30 is configured to receive the indication signal and generating a turn-on control signal in response to that the indication signal indicates that a short-circuit does not occur in the power supply 2, so that the driving unit 20 drives the SiC MOS transistors 1 to be turned on under control of the turn-on control signal. In an embodiment, the control unit 30 is a microcontroller unit (MCU). The control unit 30 may determine whether the short-circuit occurs in the power supply 2 based on a voltage magnitude of the indication signal, and send a turn-on control signal to the driving unit 20 in response to that the voltage magnitude of the indication signal does not exceed a predetermined threshold, to control the driving unit 20 to drive the SiC MOS transistor 1 to be turned on. It should be appreciated that, based on teaching provided by the present disclosure, those skilled in the art may conceive other types of control units to implement foregoing functions, and these implementations all fall within the scope of the present disclosure.

**In** an embodiment, as shown in FIG. 1, the driving unit 20 may be an operational amplifier. An inverting input end of the operational amplifier may be connected to the first output end of the state detection unit 10. A non-inverting input end of the operational amplifier may be connected to the output end of the control unit 30. A power supply end of the operational amplifier may be connected to a second end of the power supply voltage conversion unit 40. An output end of the operational amplifier may be connected to a gate of the SiC MOS transistor 1. In response to that the non-inverting input end of the operational amplifier receives the turn-on control signal, the operational amplifier can drive the SiC MOS transistor 1 to be turned on, and a voltage magnitude of a driving voltage for driving the SiC MOS transistor 1 to be turned on is equal to a voltage magnitude of a power supply voltage received by the power supply end at this time. The output end of the operational amplifier outputs the first driving voltage in response to that the power supply end of the operational amplifier receives the first power supply voltage of the first power supply. The output end of the operational amplifier outputs the second driving voltage in response to that the power supply end of the operational amplifier receives the second power supply voltage of the second power supply.

**In** an embodiment, one of the first power supply and the second power supply is used as a common power supply when the SiC MOS transistor 1 operates normally, and the other power supply is used as a protection power supply when short-circuit occurs. A voltage magnitude of a power supply voltage of the common power supply is relatively large, and a voltage magnitude of a power supply voltage of the protection power supply is relatively small. For example, the voltage magnitude of the power supply voltage of the common power supply may be 18V, and the voltage magnitude of the power supply voltage of the protection power supply may be 15V. As described above, the voltage magnitude of the driving voltage output by the output end of the operational amplifier is equal to the voltage magnitude of the supply voltage received by the supply end of the operational amplifier. Taking the first power supply as the common power supply and the second power supply as the protection power supply as an example, when the SiC MOS transistor 1 operates normally, the power supply voltage conversion unit 40 controls t the first power supply to be turned on, when the short-circuit occurs in the power supply 2, the power supply voltage conversion unit 40 controls the second power supply to be turned on, so that the driving voltage of the SiC MOS transistor 1 is converted from the first driving voltage into the second driving voltage. At this time, the indication signal received by the inverting input end of the operational amplifier is converted from a low level signal into a high level signal, so that the operational amplifier drives the SiC MOS transistor 1 to be turned off. In this way, reliability of the short-circuit protection circuit 100 can be improved by with a characteristic that the anti-short-circuit capability of the SiC MOS transistor 1 is high under a low driving voltage. In an embodiment, the power supply voltage conversion unit 40 adopts a power supply conversion switch. It should be appreciated that, based on the teaching provided by the present disclosure, those skilled in the art may conceive other types of driving units and power supply voltage conversion units to implement the foregoing functions, and these implementations all fall within the scope of the present disclosure.

**In** an embodiment, as shown in FIG. 1, the state detection unit 10 includes a resistor 101 and a signal generation unit 102. The resistor 101 is connected between the drain of the SiC MOS transistor 1 and the power supply 2. A first input end of the signal generation unit 102 is connected to a node between the resistor 101 and the power supply 2. A second input end of the signal generation unit 102 is connected to a node between the resistor 101 and the drain of the SiC MOS transistor 1. A first output end of the signal generation unit 102 is connected to a first input end of the driving unit 20 and a first end of the power supply voltage conversion unit 40, a second output end of the signal generation unit 102 is connected to an input end of the control unit 30, and the signal generation unit 102 is configured to generate the indication signal in response to that the short-circuit occurs in the power supply 2. In an embodiment, the signal generation unit 102 may be an operational amplifier. The voltage magnitude of the indication signal may be adjusted by adjusting parameters of the operational amplifier and the resistor 101, to meet operation requirements of the control unit 30. It should be appreciated that, based on the teaching provided by the present disclosure, those skilled in the art may conceive other types of signal generation units to implement foregoing functions, and these implementations all fall within the scope of the present disclosure.

With continued reference to FIG. 1, in an embodiment, the short-circuit protection circuit 100 may further include a triode 50. A base of the triode 50 is connected to the second output end of the signal generation unit 102. An emitter of the triode 50 is connected to an output end of the control unit 30. A collector of the triode 50 is connected to ground. The collector of the transistor 50 is connected to a ground end of the driving unit 20. In response to that the short-circuit occurs in the power supply 2, the voltage magnitude of the indication signal is sharply increased, and the transistor 50 is turned on in response to that the voltage magnitude of the indication signal is greater than the predetermined threshold. In response to that the triode 50 is turned on, the turn-on control signal provided by the control unit 30 can be converted from a high-level signal to a low-level signal, so that the driving unit 20 drives the SiC MOS transistor 1 to be turned off. In this way, on the basis that the indication signal directly controls the driving unit 20 to turn off the SiC MOS transistor 1, it is further ensured that the SiC MOS transistor 1 can be smoothly turned off. In response to that the short-circuit occurs in a circuit, stability of the short-circuit protection circuit 100 is improved. It should be appreciated that, based on the teaching provided by the present disclosure, those skilled in the art may conceive other types of electrical devices to implement foregoing functions, and these implementations all fall within the scope of the present disclosure.

Various embodiments of the present disclosure have been described above, which are exemplary, not exhaustive, and are not limited to disclosed embodiments. The scope of protection of the invention is defined solely by the appended claims.

## Claims

1. A short-circuit protection circuit (100) for a SiC MOS transistor (1), the short-circuit protection circuit comprising:
a state detection unit (10) connected to a drain of the SiC MOS transistor (1) and a power supply (2), and configured to generate an indication signal for indicating whether a short-circuit occurs in the power supply (2);
a driving unit (20), a first input end of the driving unit (20) being connected to a first output end of the state detection unit (10), and an output end of the driving unit (20) being connected to a gate of the SiC MOS transistor (1), to drive the SiC MOS transistor (1) to be turned off in response to that the indication signal indicates that a short-circuit occurs in the power supply (2); and
a power supply voltage conversion unit (40), a first end of the power supply voltage conversion unit (40) being connected to the state detection unit (10), to switch between a first on position for turning on a first power supply and a second on position for turning on a second power supply based on the indication signal, a second end of the power supply voltage conversion unit (40) being connected to a power supply end of the driving unit (20), to provide a first power supply voltage of the first power supply or a second power supply voltage of the second power supply to the driving unit (20), voltage magnitudes of the first power supply voltage and the second power supply voltage being different, the driving unit (20) being configured to provide a first driving voltage to the SiC MOS transistor (1) in response to receiving the first power supply voltage, the driving unit (20) being configured to provide a second driving voltage to the SiC MOS transistor (1) in response to receiving the second power supply voltage, voltage magnitudes of the first driving voltage and the first power supply voltage being the same, and voltage magnitudes of the second driving voltage and the second power supply voltage being the same.

2. The short-circuit protection circuit (100) of claim 1, **characterized in that** the short-circuit protection circuit (100) further comprises a control unit (30), an input end of the control unit (30) is connected to a second output end of the state detection unit (10), and an output end of the control unit (30) is connected to a second input end of the driving unit (20), the control unit (30) is configured to receive the indication signal and generating a turn-on control signal in response to that the indication signal indicates that a short-circuit does not occur in the power supply (2), so that the driving unit (20) drives the SiC MOS transistor (1) to be turned on under control of the turn-on control signal.

3. The short-circuit protection circuit (100) of claim 2, **characterized in that** the state detection unit (10) comprises a resistor (101) and a signal generation unit (102), the resistor (101) is connected between the drain of the SiC MOS transistor (1) and the power supply (2), a first input end of the signal generation unit (102) is connected to a node between the resistor (101) and the power supply (2), a second input end of the signal generation unit (102) is connected to a node between the resistor (101) and the drain of the SiC MOS transistor (1), a first output end of the signal generation unit (102) is connected to a first input end of the driving unit (20) and a first end of the power supply voltage conversion unit (40), a second output end of the signal generation unit (102) is connected to an input end of the control unit (30), and the signal generation unit (102) is configured to generate the indication signal in response to that a short-circuit occurs in the power supply (2).

4. The short-circuit protection circuit (100) of claim 3, **characterized in that** the short-circuit protection circuit (100) further comprises a triode (50), a base of the triode (50) is connected to the second output end of the signal generation unit (102), an emitter of the triode (50) is connected to an output end of the control unit (30), and a collector of the triode (50) is connected to ground, and the triode (50) is turned on in response to that a voltage magnitude of the indication signal is greater than a predetermined threshold.

5. The short-circuit protection circuit (100) of claim 4, **characterized in that** a ground end of the driving unit (20) is connected to the collector of the triode (50), and the driving unit (20) is configured to drive the SiC MOS transistor (1) to be turned off in response to that the triode (50) is turned on.

6. The short-circuit protection circuit (100) of any of claims 1 to 5, **characterized in that** a source of the SiC MOS transistor (1) is connected to an external load (3).

## Patentansprüche

1. Kurzschlussschutzschaltung (100) für einen SiC-MOS-Transistor (1), wobei die Kurzschlussschutzschaltung umfasst:
eine Zustandserfassungseinheit (10), die mit einem Drain des SiC-MOS Transistors (1) und einer Stromversorgung (2) verbunden und eingerichtet ist, ein Anzeigesignal zum Anzeigen zu erzeugen, ob ein Kurzschluss in der Stromversorgung (2) vorliegt;
eine Ansteuereinheit (20), wobei ein erstes Eingangsende der Ansteuereinheit (20) mit einem ersten Ausgangsende der Zustandserfassungseinheit (10) verbunden ist und ein Ausgangsende der Ansteuereinheit (20) mit einem Gate des SiC-MOS-Transistors (1) verbunden ist, um den SiC-MOS-Transistor (1) als Reaktion darauf abzuschalten, dass das Anzeigesignal anzeigt, dass ein Kurzschluss in der Stromversorgung (2) vorliegt; und
eine Stromversorgungs-Spannungsumwandlungseinheit (40), wobei ein erstes Ende der Stromversorgungs-Spannungsumwandlungseinheit (40) mit der Zustandserfassungseinheit (10) verbunden ist, um auf Grundlage des Anzeigesignals zwischen einer ersten Einschaltstellung zum Einschalten einer ersten Stromversorgung und einer zweiten Einschaltstellung zum Einschalten einer zweiten Stromversorgung umzuschalten, wobei ein zweites Ende der Stromversorgungs-spannungsumwandlungseinheit (40) mit einem Stromversorgungsende der Ansteuereinheit (20) verbunden ist, um eine erste Stromversorgungsspannung der ersten Stromversorgung oder eine zweite Stromversorgungsspannung der zweiten Stromversorgung für die Ansteuereinheit (20) bereitzustellen, wobei Spannungsgrößen der ersten Stromversorgungsspannung und der zweiten Stromversorgungsspannung verschieden sind, wobei die Ansteuereinheit (20) eingerichtet ist, als Reaktion auf das Empfangen der ersten Stromversorgungsspannung eine erste Ansteuerspannung für den SiC-MOS-Transistor (1) bereitzustellen, wobei die Ansteuereinheit (20) eingerichtet ist, eine zweite Ansteuerspannung für den SiC-MOS-Transistor (1) als Reaktion auf das Empfangen der zweiten Stromversorgungsspannung bereitzustellen, wobei Spannungsgrößen der ersten Ansteuerspannung und der ersten Stromversorgungsspannung gleich sind, und wobei Spannungsgrößen der zweiten Ansteuerspannung und der zweiten Stromversorgungsspannung gleich sind.

2. Kurzschlussschutzschaltung (100) nach Anspruch 1, **dadurch gekennzeichnet, dass** die Kurzschlussschutzschaltung (100) ferner eine Steuereinheit (30) umfasst, ein Eingangsende der Steuereinheit (30) mit einem zweiten Ausgangsende der Zustandserfassungseinheit (10) verbunden ist und ein Ausgangsende der Steuereinheit (30) mit einem zweiten Eingangsende der Ansteuereinheit (20) verbunden ist, die Steuereinheit (30) eingerichtet ist, das Anzeigesignal zu empfangen und ein Einschaltsteuersignal als Reaktion darauf zu erzeugen, dass das Anzeigesignal anzeigt, dass kein Kurzschluss in der Stromversorgung (2) vorliegt, so dass die Ansteuereinheit (20) den SiC-MOS-Transistor (1) unter der Steuerung des Einschaltsteuersignals einschaltet.

3. Kurzschlussschutzschaltung (100) nach Anspruch 2, **dadurch gekennzeichnet, dass** die Zustandserfassungseinheit (10) einen Widerstand (101) und eine Signalerzeugungseinheit (102) umfasst, der Widerstand (101) zwischen dem Drain des SiC-MOS-Transistors (1) und der Stromversorgung (2) angeschlossen ist, ein erstes Eingangsende der Signalerzeugungseinheit (102) mit einem Knoten zwischen dem Widerstand (101) und der Stromversorgung (2) verbunden ist, ein zweites Eingangsende der Signalerzeugungseinheit (102) mit einem Knoten zwischen dem Widerstand (101) und dem Drain des SiC-MOS-Transistors (1) verbunden ist, ein erstes Ausgangsende der Signalerzeugungseinheit (102) mit einem ersten Eingangsende der Ansteuereinheit (20) und einem ersten Ende der Stromversorgungsspannungsumwandlungseinheit (40) verbunden ist, ein zweites Ausgangsende der Signalerzeugungseinheit (102) mit einem Eingangsende der Steuereinheit (30) verbunden ist und die Signalerzeugungseinheit (102) eingerichtet ist, das Anzeigesignal als Reaktion darauf zu erzeugen, dass ein Kurzschluss in der Stromversorgung (2) vorliegt.

4. Kurzschlussschutzschaltung (100) nach Anspruch 3, **dadurch gekennzeichnet, dass** die Kurzschlussschutzschaltung (100) ferner eine Triode (50) umfasst, eine Basis der Triode (50) mit dem zweiten Ausgangsende der Signalerzeugungseinheit (102) verbunden ist, ein Emitter der Triode (50) mit einem Ausgangsende der Steuereinheit (30) verbunden ist und ein Kollektor der Triode (50) mit Masse verbunden ist und die Triode (50) als Reaktion darauf eingeschaltet wird, dass eine Spannungsgröße des Anzeigesignals größer als ein vorbestimmter Schwellenwert ist.

5. Kurzschlussschutzschaltung (100) nach Anspruch 4, **dadurch gekennzeichnet, dass** ein Masseende der Ansteuereinheit (20) mit dem Kollektor der Triode (50) verbunden ist und die Ansteuereinheit (20) eingerichtet ist, den SiC-MOS-Transistor (1) als Reaktion darauf abzuschalten, dass die Triode (50) eingeschaltet ist.

6. Kurzschlussschutzschaltung (100) nach einem der Ansprüche 1 bis 5, **dadurch gekennzeichnet, dass** eine Source des SiC-MOS-Transistors (1) mit einer externen Last (3) verbunden ist.

## Revendications

1. Circuit de protection contre les courts-circuits (100) pour un transistor MOS en SiC (1), le circuit de protection contre les courts-circuits comprenant:
une unité de détection d'état (10), connectée à un drain du transistor MOS en SiC (1) et à une alimentation électrique (2), et configurée pour générer un signal d'indication destiné à indiquer si un court-circuit se produit dans l'alimentation électrique (2) ;
une unité de pilotage (20), une première extrémité d'entrée de l'unité de pilotage (20) étant connectée à une première extrémité de sortie de l'unité de détection d'état (10), et une extrémité de sortie de l'unité de pilotage (20) étant connectée à une grille du transistor MOS en SiC (1), pour faire en sorte que le transistor MOS en SiC (1) soit désactivé en réponse au fait que le signal d'indication indique qu'un court-circuit se produit dans l'alimentation électrique (2) ; et
une unité de conversion de tension d'alimentation électrique (40), une première extrémité de l'unité de conversion de tension d'alimentation électrique (40) étant connectée à l'unité de détection d'état (10), pour commuter entre une première position d'activation pour activer une première alimentation électrique et une deuxième position d'activation pour activer une deuxième alimentation électrique sur la base du signal d'indication, une deuxième extrémité de l'unité de conversion de tension d'alimentation électrique (40) étant connectée à une extrémité d'alimentation électrique de l'unité de pilotage (20), pour fournir une première tension d'alimentation électrique de la première alimentation électrique ou une deuxième tension d'alimentation électrique de la deuxième alimentation électrique à l'unité de pilotage (20), des amplitudes de tension de la première tension d'alimentation électrique et de la deuxième tension d'alimentation électrique étant différentes, l'unité de pilotage (20) étant configurée pour fournir une première tension de pilotage au transistor MOS en SiC (1) en réponse à la réception de la première tension d'alimentation électrique, l'unité de pilotage (20) étant configurée pour fournir une deuxième tension de pilotage au transistor MOS en SiC (1) en réponse à la réception de la deuxième tension d'alimentation électrique, des amplitudes de tension de la première tension de pilotage et de la première tension d'alimentation électrique étant identiques, et des amplitudes de tension de la deuxième tension de pilotage et de la deuxième tension d'alimentation électrique étant identiques.

2. Circuit de protection contre les courts-circuits (100) selon la revendication 1, **caractérisé en ce que** le circuit de protection contre les courts-circuits (100) comprend en outre une unité de commande (30), une extrémité d'entrée de l'unité de commande (30) étant connectée à une deuxième extrémité de sortie de l'unité de détection d'état (10), et une extrémité de sortie de l'unité de commande (30) étant connectée à une deuxième extrémité d'entrée de l'unité de pilotage (20), l'unité de commande (30) étant configurée pour recevoir le signal d'indication et générer un signal de commande d'activation en réponse au fait que le signal d'indication indique qu'aucun court-circuit ne se produit dans l'alimentation électrique (2), de sorte que l'unité de pilotage (20) commande le transistor MOS en SiC (1) pour qu'il soit activé sous la commande du signal de commande d'activation.

3. Circuit de protection contre les courts-circuits (100) selon la revendication 2, **caractérisé en ce que** l'unité de détection d'état (10) comprend une résistance (101) et une unité de génération de signal (102), la résistance (101) étant connectée entre le drain du transistor MOS en SiC (1) et l'alimentation électrique (2), une première extrémité d'entrée de l'unité de génération de signal (102) étant connectée à un nœud entre la résistance (101) et l'alimentation électrique (2), une deuxième extrémité d'entrée de l'unité de génération de signal (102) étant connectée à un nœud entre la résistance (101) et le drain du transistor MOS en SiC (1), une première extrémité de sortie de l'unité de génération de signal (102) étant connectée à une première extrémité d'entrée de l'unité de pilotage (20) et à une première extrémité de l'unité de conversion de tension d'alimentation électrique (40), une deuxième extrémité de sortie de l'unité de génération de signal (102) étant connectée à une extrémité d'entrée de l'unité de commande (30), et l'unité de génération de signal (102) étant configurée pour générer le signal d'indication en réponse au fait qu'un court-circuit se produit dans l'alimentation électrique (2).

4. Circuit de protection contre les courts-circuits (100) selon la revendication 3, **caractérisé en ce que** le circuit de protection contre les courts-circuits (100) comprend en outre une triode (50), une base de la triode (50) étant connectée à la deuxième extrémité de sortie de l'unité de génération de signal (102), un émetteur de la triode (50) étant connecté à une extrémité de sortie de l'unité de commande (30), et un collecteur de la triode (50) étant connecté à la masse, et la triode (50) étant activée en réponse au fait qu'une amplitude de tension du signal d'indication est supérieure à un seuil prédéterminé.

5. Circuit de protection contre les courts-circuits (100) selon la revendication 4, **caractérisé en ce qu'**une extrémité de masse de l'unité de pilotage (20) est connectée au collecteur de la triode (50), et l'unité de pilotage (20) est configurée pour désactiver le transistor MOS en SiC (1) en réponse au fait que la triode (50) est activée.

6. Circuit de protection contre les courts-circuits (100) selon l'une des revendications 1 à 5, **caractérisé en ce qu'**une source du transistor MOS en SiC (1) est connectée à une charge externe (3).
